# EUROPEAN PATENT APPLICATION

(11) **EP 4 109 547 A1**
(43) Date of publication of application: **28.12.2022**
(21) Application number: 22171255.7
(22) Date of filing: 03.05.2022
(51) Int. Cl.: H01L 29/06, H01L 21/336, H01L 29/775, H01L 21/8234, H01L 29/423

(54) **NANORIBBON SUBFIN ISOLATION BY BACKSIDE SILICON SUBSTRATE REMOVAL WITH EPI PROTECTION**

(30) Priority: 24.06.2021 US 202117357895
(71) Applicant: INTEL Corporation, Santa Clara, CA 95054 (US)
(72) Inventor: Hasan, Mohammad, Aloha, 97003 (US); Hsu, William, Portland, 97229 (US); Guha, Biswajeet, Hillsboro, 97124 (US); Golonzka, Oleg, Beaverton, 97007 (US); Ghani, Tahir, Portland, 97229 (US); Thirtha, Vivek, Portland, 97229 (US); Kumar, Nitesh, Beaverton, 97006 (US)
(74) Representative: Goddar, Heinz J.

(57) **Abstract**

Embodiments disclosed herein include semiconductor devices and methods of making semiconductor devices. In an embodiment, a semiconductor device comprises a substrate, where the substrate is a dielectric material, and a vertical stack of semiconductor channels over the substrate. In an embodiment, the semiconductor device further comprises a source at a first end of the semiconductor channels, a drain at a second end of the semiconductor channels, and a barrier between a bottom surface of the source and the substrate.

## Description

### TECHNICAL FIELD

Embodiments of the disclosure are in the field of semiconductor structures and processing and, in particular, to nanoribbon transistors with subfin isolation that includes source/drain epi protection.

### BACKGROUND

Gate-all-around (GAA) transistors have begun being utilized as scaling continues to reduce feature sizes of transistor devices. In a GAA device, such as a nanoribbon or nanowire architecture, the semiconductor channels are formed as part of a fin with alternating sacrificial layers. During processing, the sacrificial layers are removed from the fin and a gate stack is provided around the semiconductor channels. However, scaling to smaller critical dimensions in GAA technologies is not without issue. Particularly, a stronger subfin implant is needed to suppress leakage current as the channel length is reduced. High energy dose implants carry the risk of introducing defects into the active semiconductor channels.

On solution is to remove the subfin from the device. Removal of the subfin and replacement with a dielectric, such as an interlayer dielectric (ILD) can minimize subfin leakage issues. However, removing the subfin typically results in damage to the epitaxially grown source/drain region. As such, there is currently no suitable approach for mitigating subfin leakage without also damaging the epitaxially grown source/drain regions.

### BRIEF DESCRIPTION OF THE DRAWINGS

Figure 1 is a cross-sectional illustration of a semiconductor device with a barrier below the source/drain region in a gate-all-around (GAA) transistor device, in accordance with an embodiment.
Figure 2A is a cross-sectional illustration of a fin with a trench for the source/drain region, in accordance with an embodiment.
Figure 2B is a cross-sectional illustration of the fin after recesses are made into the sacrificial layers, in accordance with an embodiment.
Figure 2C is a cross-sectional illustration of the fin after a cavity spacer is deposited, in accordance with an embodiment.
Figure 2D is a cross-sectional illustration of the fin after a mask is formed over the bottom of the cavity spacer, in accordance with an embodiment.
Figure 2E is a cross-sectional illustration of the fin after the cavity spacer is etched to define a barrier at the bottom of the source/drain trench, in accordance with an embodiment.
Figure 2F is a cross-sectional illustration of the fin after the mask is removed, in accordance with an embodiment.
Figure 2G is a cross-sectional illustration of the fin after a source/drain epitaxial layer is grown in the source/drain trench, in accordance with an embodiment.
Figure 2H is a cross-sectional illustration of the fin after the sacrificial layers are removed and replaced by a gate stack, in accordance with an embodiment.
Figure 21 is a cross-sectional illustration of the fin after the subfin substrate is removed, in accordance with an embodiment.

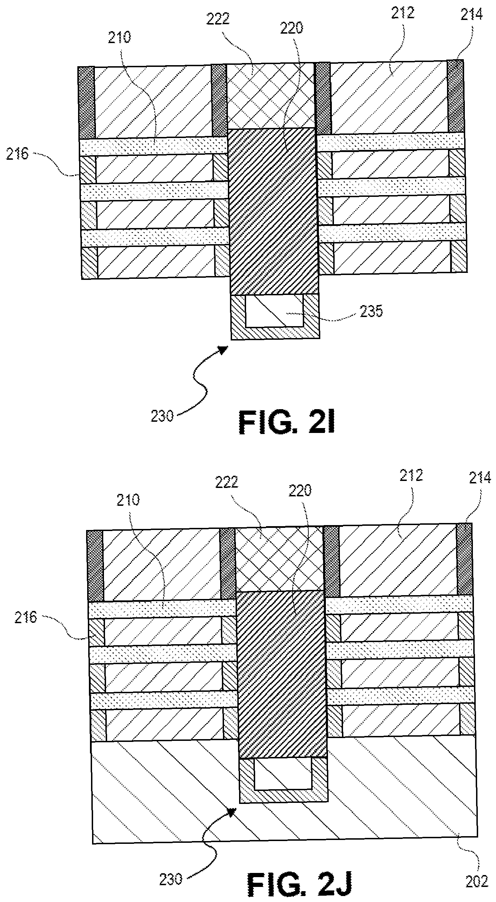

Figure 2J is a cross-sectional illustration of the fin after an ILD is filled below the transistor, in accordance with an embodiment.

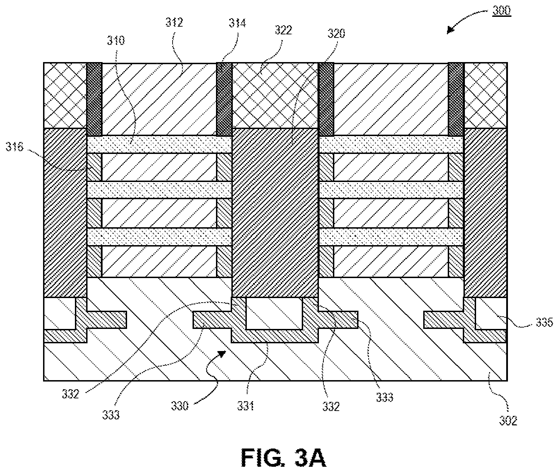

Figure 3A is a cross-sectional illustration of a GAA transistor device with a barrier with wings below the source/drain epitaxial region, in accordance with an embodiment.

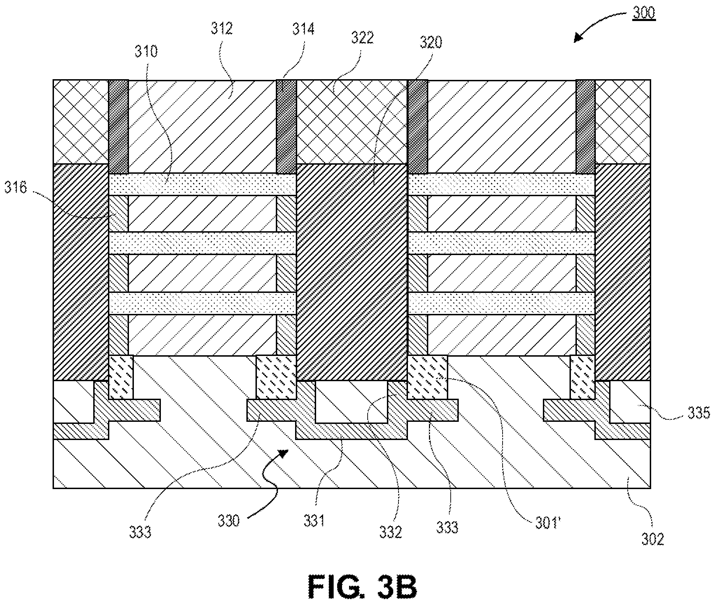

Figure 3B is a cross-sectional illustration of a GAA transistor device with a barrier with wings and residual semiconductor material behind the wings, in accordance with an embodiment.

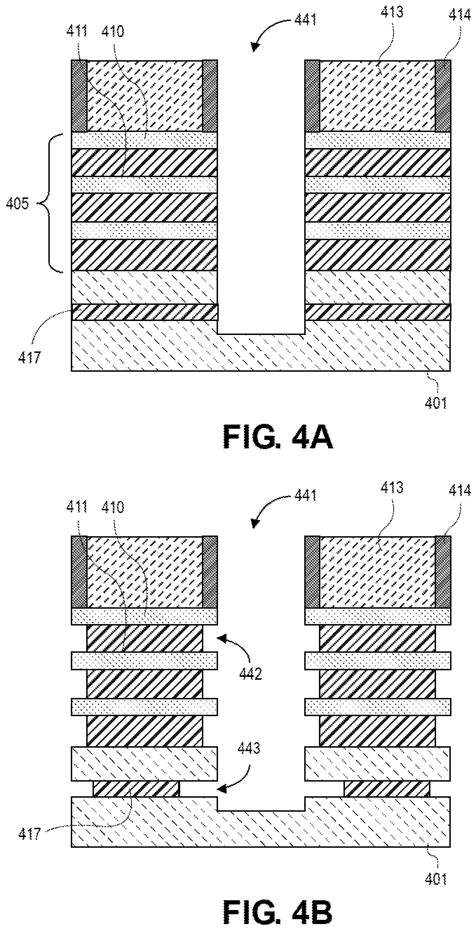

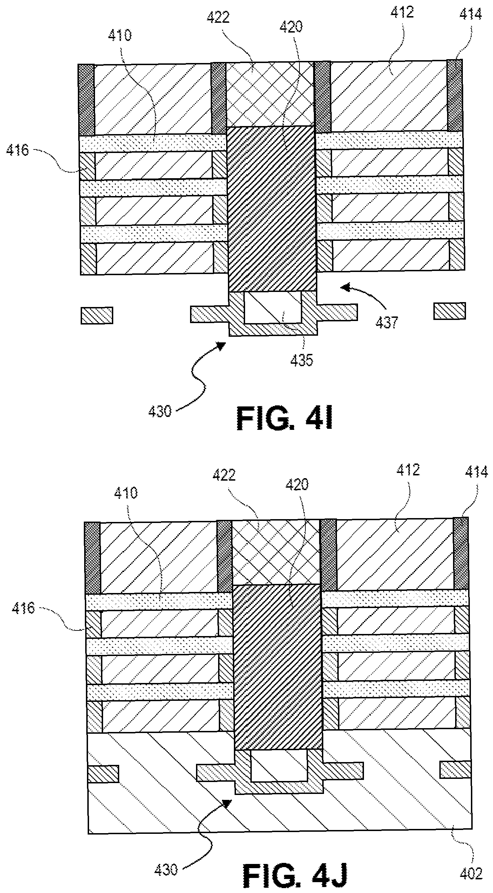

Figure 4A is a cross-sectional illustration of a fin with a trench for the source/drain region, in accordance with an embodiment.
Figure 4B is a cross-sectional illustration of the fin after recesses are made into the sacrificial layers, in accordance with an embodiment.

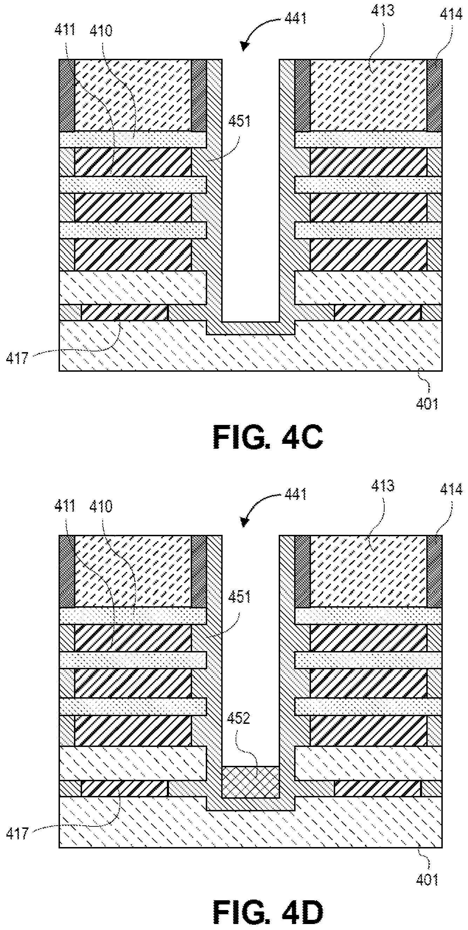

Figure 4C is a cross-sectional illustration of the fin after a cavity spacer is deposited, in accordance with an embodiment.
Figure 4D is a cross-sectional illustration of the fin after a mask is formed over the bottom of the cavity spacer, in accordance with an embodiment.

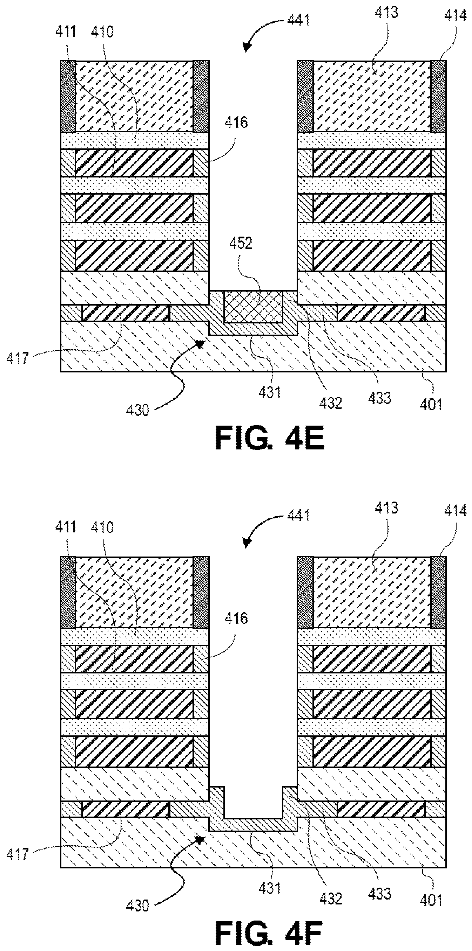

Figure 4E is a cross-sectional illustration of the fin after the cavity spacer is etched to define a barrier at the bottom of the source/drain trench, in accordance with an embodiment.
Figure 4F is a cross-sectional illustration of the fin after the mask is removed, in accordance with an embodiment.

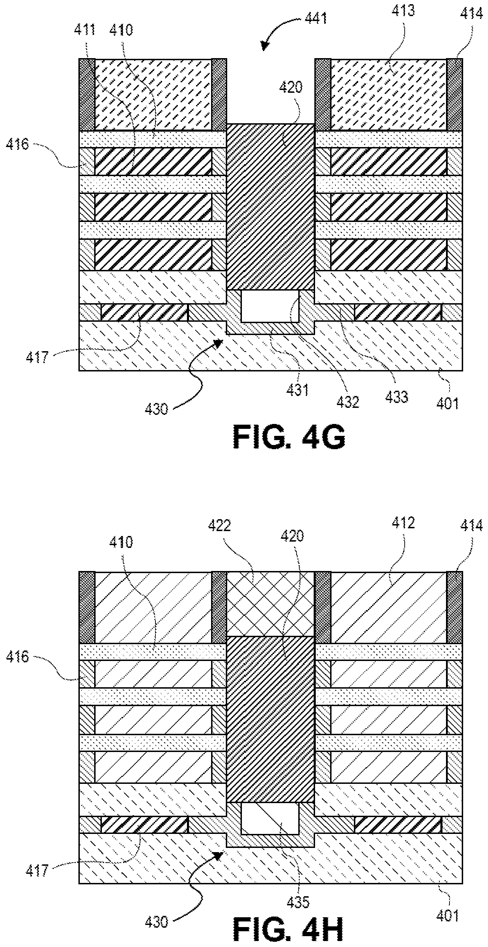

Figure 4G is a cross-sectional illustration of the fin after a source/drain epitaxial layer is grown in the source/drain trench, in accordance with an embodiment.
Figure 4H is a cross-sectional illustration of the fin after the sacrificial layers are removed and replaced by a gate stack, in accordance with an embodiment.
Figure 41 is a cross-sectional illustration of the fin after the subfin substrate is removed, in accordance with an embodiment.
Figure 4J is a cross-sectional illustration of the fin after an ILD is filled below the transistor, in accordance with an embodiment.

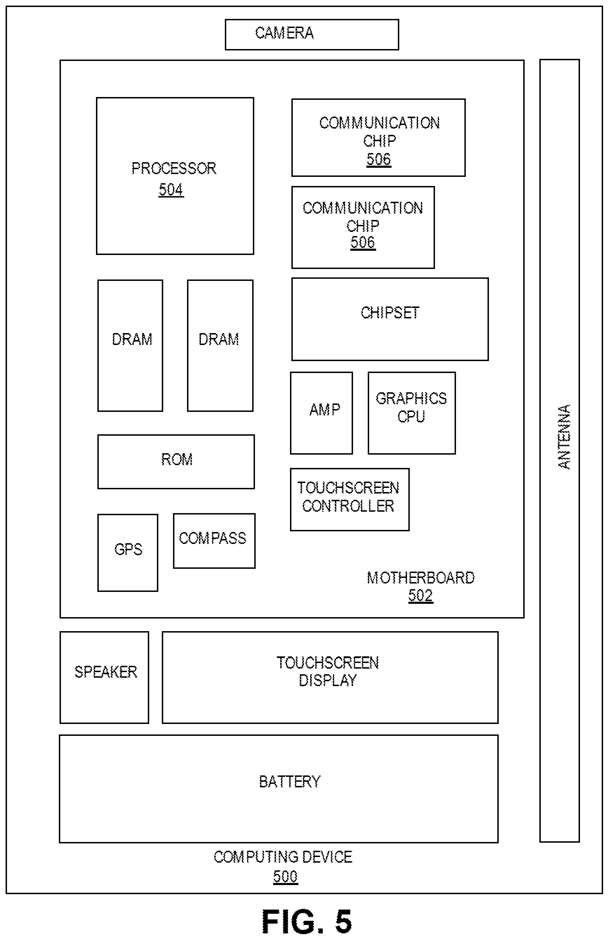

Figure 5 illustrates a computing device in accordance with one implementation of an embodiment of the disclosure.

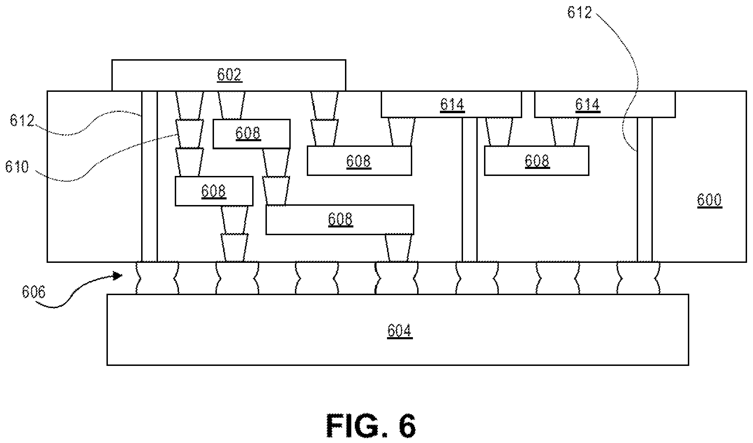

Figure 6 is an interposer implementing one or more embodiments of the disclosure.

### DESCRIPTION OF THE EMBODIMENTS

Embodiments described herein comprise nanoribbon transistors with subfin isolation that includes source/drain epi protection. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

As noted above, the scaling to smaller channel lengths results in the need to provide greater protection against subfin leakage. Typically, this is done by having a heavy dopant implant into the subfin. However, such high energy/dose implants introduce the risk of defects in the active channels. Additionally, removing the semiconductor subfin is also not currently a possibility. This is due to the damage that an etching process will have on the exposed source/drain regions.

Accordingly, embodiments disclosed herein include GAA structures with a barrier between the source/drain region and the underlying subfin. The barrier can function as an etchstop layer that allows for an etching of the subfin without damaging the source/drain region. As such, subfin leakage can be avoided since the subfin is removed and replaced with an ILD. Additionally, there is no need for high energy implants that would otherwise damage the semiconductor channels.

In some embodiments, the barrier has a u-shaped cross-section. The u-shaped cross-section is the result of the barrier being conformally deposited into the source/drain trench before the source/drain region is grown. The u-shape may include a horizontal section and a pair of vertical sections. The vertical sections may extend up from the horizontal section and contact a bottom surface of the source/drain region. In yet another embodiment, the barrier further comprises wings that extend laterally away from the vertical sections. The wings provide even greater protection to the source/drain regions during the etching of the subfin.

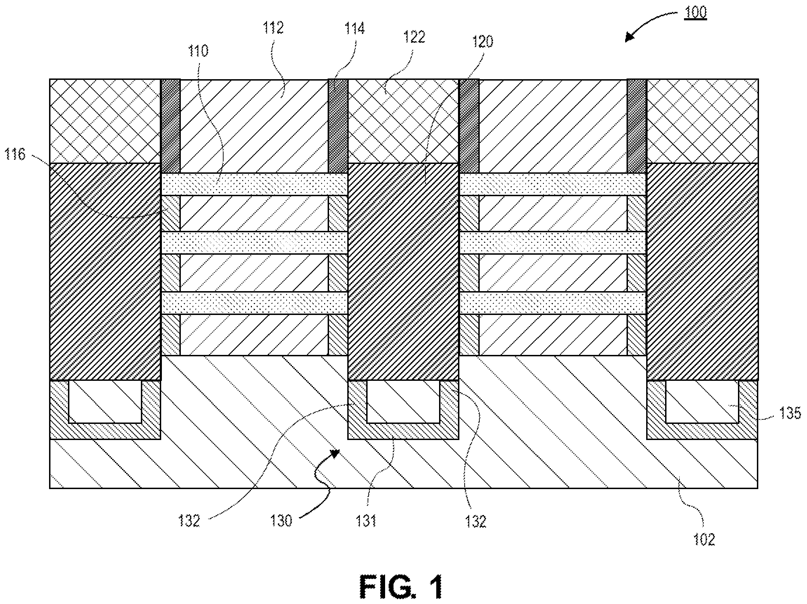

Referring now to Figure 1, a cross-sectional illustration of a transistor device 100 is shown, in accordance with an embodiment. In an embodiment, the transistor device 100 is a GAA transistor device, such as a nanowire device or a nanoribbon device. As shown in Figure 1, a vertical stack of semiconductor channels 110 are surrounded by a gate stack 112. The semiconductor channels 110 may be any suitable semiconductor material, such as, but not limited to, silicon, germanium, SiGe, GaAs, InSb, GaP, GaSb, InAlAs, InGaAs, GaSbP, GaAsSb, and InP. The semiconductor channels 110 may be nanowires (i.e., with a width and thickness that are substantially uniform) or nanoribbons (i.e., with a width and thickness that are substantially different).

While shown as a single material, it is to be appreciated that the gate stack 112 may comprises a gate dielectric over the semiconductor channels 110, a workfunction metal, and a fill metal. The gate dielectric may be, for example, any suitable oxide such as silicon dioxide or high-k gate dielectric materials. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

When the work function metal will serve as an N-type workfunction metal, the work function metal preferably has a workfunction that is between about 3.9 eV and about 4.2 eV. N-type materials that may be used to form the work function metal include, but are not limited to, hafnium, zirconium, titanium, tantalum, aluminum, and metal carbides that include these elements, i.e., titanium carbide, zirconium carbide, tantalum carbide, hafnium carbide and aluminum carbide. When the work function metal will serve as a P-type workfunction metal, the work function metal preferable has a workfunction that is between about 4.9 eV and about 5.2 eV. P-type materials that may be used to form the work function metal include, but are not limited to, ruthenium, palladium, platinum, cobalt, nickel, and conductive metal oxides, e.g., ruthenium oxide. In an embodiment, the gate fill metal may comprise materials such as polysilicon, silicon nitride, silicon carbide, or various suitable metals or metal alloys, such as aluminum (Al), tungsten (W), titanium (Ti), tantalum (Ta), copper (Cu), titanium nitride (TiN), or tantalum nitride (TaN), for example.

In an embodiment, spacers 114 and 116 may isolate the channel region from the source/drain regions 120. The spacers 114 and 116 may comprise dielectric materials, such as silicon oxides, silicon nitrides, and the like. In an embodiment, the spacers 114 may be a different material than the spacers 116. In other embodiments, the spacers 114 may be substantially similar in material composition as the spacers 116.

In an embodiment, source/drain regions 120 are provided on opposite ends of the semiconductor channels 110. The fin may be etched to form a recess that is filled with an epitaxially grown semiconductor to form the source/drain regions 120. In an embodiment, the source/drain regions 120 may comprise a silicon alloy that may be in-situ doped silicon germanium, in-situ doped silicon carbide, or in-situ doped silicon. In alternate implementations, other silicon alloys may be used. For instance, alternate silicon alloy materials that may be used include, but are not limited to, nickel silicide, titanium silicide, cobalt silicide, and possibly may be doped with one or more of boron and/or aluminum. In some implementations, a chemical vapor deposition (CVD) process may be used for the epitaxial deposition of the source/drain regions 120. Source/drain contacts 122 may be provided over the source/drain regions 120. The source/drain contacts 122 may comprise any suitable material or materials. For example, the source/drain contacts 122 may comprise metals or metal alloys, such as aluminum (Al), tungsten (W), titanium (Ti), tantalum (Ta), copper (Cu), titanium nitride (TiN), or tantalum nitride (TaN), for example.

In an embodiment, the transistor device 100 is provided over a dielectric substrate 102, such as an interlayer dielectric (ILD). In an embodiment, ILD materials may comprise a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, CVD, physical vapor deposition (PVD), or by other deposition methods.

The replacement of a semiconductor subfin with a dielectric substrate 102 allows for substantially eliminating subfin leakage. As such, the heavy doping process needed in the case of a semiconductor subfin is avoided all together. However, it is to be appreciated that the removal of the semiconductor subfin is not without issue. Accordingly, embodiments disclosed herein include a transistor device 100 that further comprises a barrier 130. The barrier 130 protects the bottom surface of the source/drain region 120 during the etching process used to remove the semiconductor subfin.

As shown in Figure 1, the barrier 130 may have a u-shaped cross-section. The u-shaped cross-section may comprise a horizontal portion 131 and a pair a vertical portions 132 on opposite ends of the horizontal portion 131. The vertical portions 132 may extend up and contact the bottom surface of the source/drain region 120. Additionally, a width of the barrier 130 (e.g., from the left side of the left vertical portion 132 to the right side of the right vertical portion 132) may be substantially equal to a width of the source/drain region 120. As will be described in greater detail below, the uniform widths are the result of the barrier 130 being deposited in the same trench used to form source/drain region 120. In an embodiment, the space defined by a bottom surface of the source/drain region 120 and the interior surface of the barrier 130 may be filled with an insulative material 135, such as an oxide material. The insulative material 135 may be the same material as the dielectric substrate 102. In other embodiments, the insulative material 135 is a different material than the dielectric substrate 102. In yet another embodiment, the space may be left as a void.

In an embodiment, the barrier 130 may be a material that is etch selective to the semiconductor subfin. For example, the barrier 130 may comprise an oxide or a nitride. In a particular embodiment, the barrier 130 may be the same material as the spacers 116. Particularly, as will be described in greater detail below, the spacers 116 and the barrier 130 may be formed with the same deposition process.

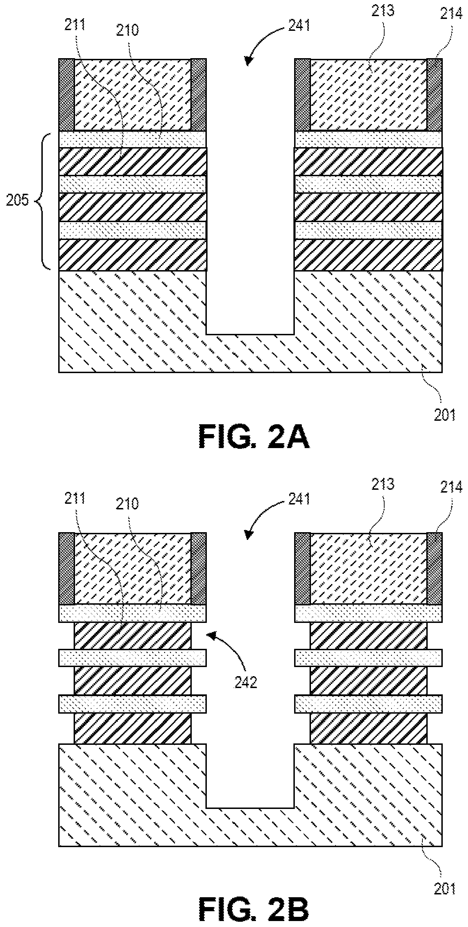

Referring now to Figures 2A-2J, a series of cross-sectional illustrations depicting a process for fabricating a transistor device is shown, in accordance with an embodiment. The transistor device that is fabricated in Figures 2A-2J may be substantially similar to the transistor device 100 illustrated in Figure 1.

Referring now to Figure 2A, a cross-sectional illustration of a nanowire stack 205 is shown, in accordance with an embodiment. While referred to as a nanowire stack 205, it is to be appreciated that a nanoribbon stack may also be used, in accordance with embodiments disclosed herein. Nanowire stack 205 may be formed by known methods, such as forming alternating layers of nanowire 210 and sacrificial material 211 over a substrate 201, and then etching the layers to form a fin-type structure (e.g., with a mask and plasma etch process). In an embodiment, sacrificial material 211 may be any material that can be selectively etched with respect to nanowires 210. Nanowires 210 and sacrificial material 211 may each be a material such as, but not limited to, silicon, germanium, SiGe, GaAs, InSb, GaP, GaSb, InAlAs, InGaAs, GaSbP, GaAsSb, and InP. In a specific embodiment, nanowires 210 are silicon and sacrificial material 211 is SiGe. In another specific embodiment, nanowires 210 are germanium, and sacrificial material 211 is SiGe.

In an embodiment, the substrate 201 represents a general workpiece object used to manufacture integrated circuits. The semiconductor substrate 201 often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials.

In an embodiment, a sacrificial gate electrode 213 is provided over the nanowire stack 205. The sacrificial gate electrode 213 may be disposed over a top surface of the nanowire stack 205 and wrap down the sides of the nanowire stack 205 (into and out of the plane of Figure 2A). The sacrificial gate electrode 213 may be lined by a spacer 214. The spacer 214 may comprise an oxide, a nitride, or any other suitable spacer material.

In an embodiment, a source/drain trench 241 is provided through the nanowire stack 205. The source/drain trench 241 is located where the source/drain will be located in the final structure. In an embodiment, the source/drain trench 241 extends through an entire thickness of the nanowire stack 205 and extends into the substrate 201. The source/drain trench 241 may be formed with an etching process.

Referring now to Figure 2B, a cross-sectional illustration of the device after a cavity etch is implemented is shown, in accordance with an embodiment. In an embodiment, the cavity etch results in cavities 242 being formed in the nanowire stack 205. The cavities 242 result from the recessing of the sacrificial layers 211. In an embodiment, the cavities 242 may be formed with an etching process that is selective to the sacrificial layers 211 over the nanowires 210.

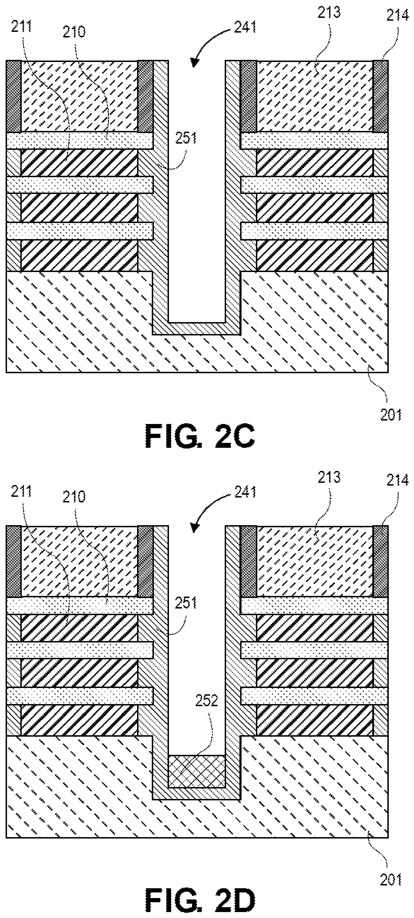

Referring now to Figure 2C, a cross-sectional illustration of the device after a cavity spacer 251 is deposited is shown, in accordance with an embodiment. In an embodiment, the cavity spacer 251 fills the cavities 242 and lines a surface of the source/drain trench 241. In an embodiment, the cavity spacer 251 is conformally deposited, e.g., with an atomic layer deposition (ALD) process or a CVD process. In an embodiment, the cavity spacer 251 is a material that is etch selective to the substrate 201. In a particular embodiment, the cavity spacer 251 comprises an oxide material or a nitride material.

Referring now to Figure 2D, a cross-sectional illustration of the device after a mask 252 is disposed in the source/drain trench 241 is shown, in accordance with an embodiment. In an embodiment, mask 252 is a hardmask. The mask 252 may be deposited into the source/drain trench 241 and recessed so that a top surface of the mask 252 is at or below a top surface of the substrate 201.

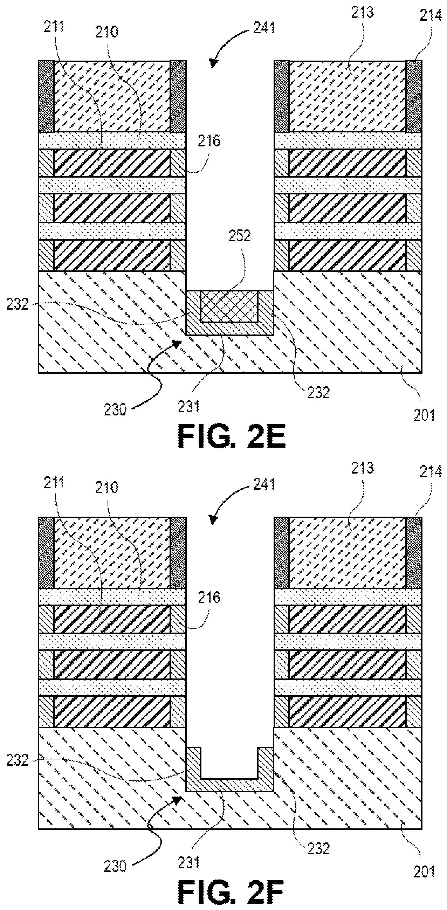

Referring now to Figure 2E, a cross-sectional illustration of the device after a spacer etching process is implemented is shown, in accordance with an embodiment. The etching process may result in the cavity spacer 251 being segmented. That is, spacers 216 may remain adjacent to the sacrificial layers 211, and a barrier 230 is provided at the bottom of the source/drain trench 241. The mask 252 protects the barrier 230 and prevents it from being etched away. The barrier 230 may comprise a u-shaped cross-section. For example, the barrier 230 may comprise a horizontal portion 231 and a pair of vertical portions 232 extending up from opposite ends of the horizontal portion 231.

Referring now to Figure 2F, a cross-sectional illustration of the device after the mask 252 is removed is shown, in accordance with an embodiment. The mask 252 may be removed with any suitable process, such as an ashing process or the like.

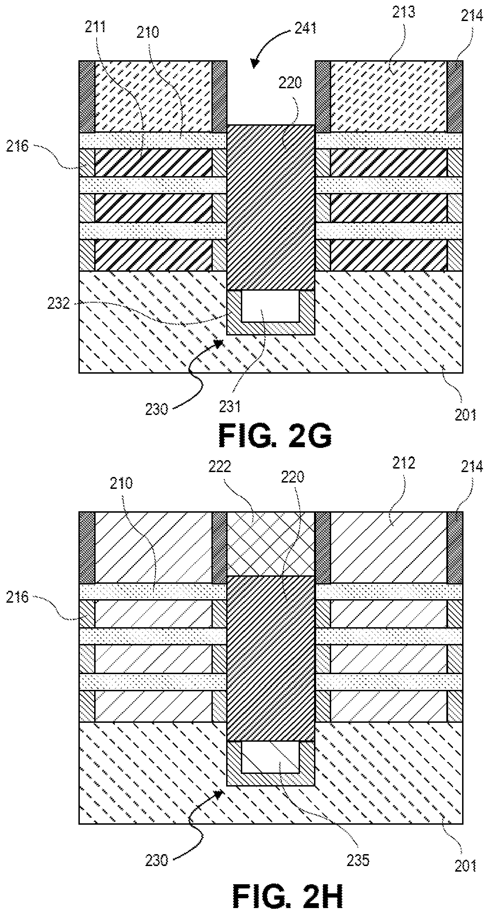

Referring now to Figure 2G, a cross-sectional illustration of the device after a source/drain region 220 is grown in the source/drain trench 241 is shown, in accordance with an embodiment. The source/drain region 220 may be grown with an epitaxial deposition process. The growth may start at the ends of the nanowires 210 and extend out until the source/drain trench 241 is filled. Since the source/drain trench 241 confines the growth of the source/drain region 220, a width of the barrier 230 may be substantially equal to a width of the source/drain region 220. In an embodiment, the u-shaped cross-section of the barrier 230 may result in the formation of a gap between a bottom surface of the source/drain region 220 and the horizontal portion 231 of the barrier 230. However, it is to be appreciated that the vertical portions 232 may extend up and contact a bottom surface of the source/drain region 220.

Referring now to Figure 2H, a cross-sectional illustration of the device after the gate stack 212 is deposited is shown, in accordance with an embodiment. In an embodiment, the sacrificial layers 211 are removed with an etching process. Sacrificial layers 211 may be removed using any known etchant that is selective to nanowires 210. The selectivity of the etchant is greater than 50:1 for sacrificial material over nanowire material. In an embodiment, the selectivity is greater than 100:1. In an embodiment where nanowires 210 are silicon and sacrificial layers 211 are silicon germanium, sacrificial layers 211 are selectively removed using a wet etchant such as, but not limited to, aqueous carboxylic acid/nitric acid/HF solution and aqueous citric acid/nitric acid/HF solution. In an embodiment where nanowires 210 are germanium and sacrificial layers 211 are silicon germanium, sacrificial layers 211 are selectively removed using a wet etchant such as, but not limited to, ammonium hydroxide (NH₄OH), tetramethylammonium hydroxide (TMAH), ethylenediamine pyrocatechol (EDP), or potassium hydroxide (KOH) solution. In another embodiment, sacrificial layers 211 are removed by a combination of wet and dry etch processes.

After removal of the sacrificial layers 211, a gate stack 212 is disposed over the nanowires 210. The gate stack 212 may comprise a gate dielectric in direct contact with the nanowires 210. A workfunction metal may then be disposed over the gate dielectric. A fill metal may then be disposed over the workfunction metal. Materials suitable for the gate dielectric, workfunction metal, and fill metal are described in greater detail above, and will not be repeated here.

In an embodiment, the processing in Figure 2H may further comprise forming a contact 222 to the source/drain region 220. The contact 222 may be any suitable conductive material. The contact 222 may be separated from the gate stack 212 by the spacers 214. Additionally, an insulating plug 235 may be disposed in the gap between the barrier 230 and the bottom of the source/drain region 220. The insulating plug 235 may comprise an oxide or the like.

Referring now to Figure 21, a cross-sectional illustration of the device after the substrate 201 is removed is shown, in accordance with an embodiment. In an embodiment, the substrate 201 may be removed with an etching process. In an embodiment, the etching process is an isotropic etching process. The barrier 230 protects the bottom surface of the source/drain region 220 during the etching process. As such, damage to the source/drain region 220 is avoided.

Referring now to Figure 2J, a cross-sectional illustration of the device after a replacement substrate 202 is provided on the backside is shown, in accordance with an embodiment. In an embodiment, the replacement substrate 202 may comprise an ILD material, such as those described in greater detail above. The low conductivity of the replacement substrate 202 substantially eliminates the problem of subfin leakage. As such, improved performance is provided for nanowire devices, without the need for high concentration doping of the substrate, and without damaging the source/drain region during the substrate replacement.

Referring now to Figure 3A, a cross-sectional illustration of a transistor device 300 is shown, in accordance with an additional embodiment. In an embodiment, the transistor device 300 comprises nanowires (or nanoribbons) 310 between source/drain regions 320. A gate stack 312 is provided over the nanowires 310. A source/drain contact 322 is provided over the source/drain region 320. Spacers 314 and 316 may separate the channel region from the source/drain region 320. In an embodiment, a backside substrate 302 comprises an ILD material. In an embodiment, the transistor device 300 may be substantially similar to the transistor device 100 in Figure 1, with the exception of the structure of the barrier 330.

In an embodiment, the barrier 330 may comprise a u-shaped cross-section with wings. For example, the barrier 330 comprises a horizontal portion 331 and a pair of vertical portions 332 extend up to the source/drain region 320. Additionally, a pair of wings 333 may extend out from the vertical portions 332. The wings 333 provide additional protection to the source/drain region 320 during the substrate removal and replacement. In an embodiment, an insulating plug 335 may fill the space between the barrier 330 and the source/drain region 320.

Referring now to Figure 3B, a cross-sectional illustration of a transistor device 300 is shown, in accordance with an additional embodiment. In an embodiment, the transistor device 300 in Figure 3B may be substantially similar to the transistor device 300 in Figure 3A, with the exception of the presence of residual substrate 301'. The residual substrate 301' may persist into the final structure in some embodiments where the substrate removal operation does not fully clear all of the semiconductor substrate (e.g., silicon). Particularly, the wings 333 may protect portions of the original substrate during the etching process. As such, the residual substrate 301' may be located above the wings 333.

Referring now to Figures 4A-4J, a series of cross-sectional illustrations depicting a process for forming a nanowire (or nanoribbon) transistor device similar to the ones in Figures 3A and 3B is shown, in accordance with an embodiment.

Referring now to Figure 4A, a cross-sectional illustration of a nanowire stack 405 is shown, in accordance with an embodiment. While referred to as a nanowire stack 405, it is to be appreciated that a nanoribbon stack may also be used, in accordance with embodiments disclosed herein. Nanowire stack 405 may be formed by known methods, such as forming alternating layers of nanowire 410 and sacrificial material 411 over a substrate 401, and then etching the layers to form a fin-type structure (e.g., with a mask and plasma etch process). Materials for the sacrificial material 411 and the nanowires 410 may be similar to materials described above with respect to Figure 2A. In an embodiment, a buried sacrificial layer 417 may be provided in the substrate 401. The buried sacrificial layer 417 may be the same material as the sacrificial material 411. The substrate 401 may be a semiconductor material, such as silicon or the like.

In an embodiment, a sacrificial gate electrode 413 is provided over the nanowire stack 405. The sacrificial gate electrode 413 may be disposed over a top surface of the nanowire stack 405 and wrap down the sides of the nanowire stack 405 (into and out of the plane of Figure 4A). The sacrificial gate electrode 413 may be lined by a spacer 414. The spacer 414 may comprise an oxide, a nitride, or any other suitable spacer material.

In an embodiment, a source/drain trench 441 is provided through the nanowire stack 405. The source/drain trench 441 is located where the source/drain will be located in the final structure. In an embodiment, the source/drain trench 441 extends through an entire thickness of the nanowire stack 405 and extends into the substrate 401 past the buried sacrificial layer 417. The source/drain trench 441 may be formed with an etching process.

Referring now to Figure 4B, a cross-sectional illustration of the device after a cavity etch is implemented is shown, in accordance with an embodiment. In an embodiment, the cavity etch results in cavities 442 being formed in the nanowire stack 405. The cavities 442 result from the recessing of the sacrificial layers 411. In an embodiment, the cavities 442 may be formed with an etching process that is selective to the sacrificial layers 411 over the nanowires 410. The cavity etching process may also result in the formation of a cavity 443 adjacent to the buried sacrificial layer 417.

Referring now to Figure 4C, a cross-sectional illustration of the device after a cavity spacer 451 is deposited is shown, in accordance with an embodiment. In an embodiment, the cavity spacer 451 fills the cavities 442, 443, and lines a surface of the source/drain trench 441. In an embodiment, the cavity spacer 451 is conformally deposited, e.g., with an ALD process or a CVD process. In an embodiment, the cavity spacer 451 is a material that is etch selective to the substrate 401. In a particular embodiment, the cavity spacer 451 comprises an oxide material or a nitride material.

Referring now to Figure 4D, a cross-sectional illustration of the device after a mask 452 is disposed in the source/drain trench 441 is shown, in accordance with an embodiment. In an embodiment, mask 452 is a hardmask. The mask 452 may be deposited into the source/drain trench 441 and recessed so that a top surface of the mask 452 is at or below a top surface of the substrate 401. A top surface of the mask 452 is also provided at a height above the buried sacrificial layer 417.

Referring now to Figure 4E, a cross-sectional illustration of the device after a spacer etching process is implemented is shown, in accordance with an embodiment. The etching process may result in the cavity spacer 451 being segmented. That is, spacers 416 may remain adjacent to the sacrificial layers 411, and a barrier 430 is provided at the bottom of the source/drain trench 441. The mask 452 protects the barrier 430 and prevents it from being etched away. The barrier 430 may comprise a u-shaped cross-section with wings. For example, the barrier 430 may comprise a horizontal portion 431 and a pair of vertical portions 432 extending up from opposite ends of the horizontal portion 431. The wings 433 extend out laterally from the vertical portions 432.

Referring now to Figure 4F, a cross-sectional illustration of the device after the mask 452 is removed is shown, in accordance with an embodiment. The mask 452 may be removed with any suitable process, such as an ashing process or the like.

Referring now to Figure 4G, a cross-sectional illustration of the device after a source/drain region 420 is grown in the source/drain trench 441 is shown, in accordance with an embodiment. The source/drain region 420 may be grown with an epitaxial deposition process. The growth may start at the ends of the nanowires 410 and extend out until the source/drain trench 441 is filled. Since the source/drain trench 441 confines the growth of the source/drain region 420, a width of the barrier 430 (excluding the wings 433) may be substantially equal to a width of the source/drain region 420. In an embodiment, the u-shaped cross-section of the barrier 430 may result in the formation of a gap between a bottom surface of the source/drain region 420 and the horizontal portion 431 of the barrier 430. However, it is to be appreciated that the vertical portions 432 may extend up and contact a bottom surface of the source/drain region 420.

Referring now to Figure 4H, a cross-sectional illustration of the device after the gate stack 412 is deposited is shown, in accordance with an embodiment. In an embodiment, the sacrificial layers 411 are removed with an etching process. Sacrificial layers 411 may be removed using any known etchant that is selective to nanowires 210. The etching process may be substantially similar to the etching process described above with respect to Figure 2H, and will not be repeated here.

After removal of the sacrificial layers 411, a gate stack 412 is disposed over the nanowires 410. The gate stack 412 may comprise a gate dielectric in direct contact with the nanowires 410. A workfunction metal may then be disposed over the gate dielectric. A fill metal may then be disposed over the workfunction metal. Materials suitable for the gate dielectric, workfunction metal, and fill metal are described in greater detail above, and will not be repeated here.

In an embodiment, the processing in Figure 4H may further comprise forming a contact 422 to the source/drain region 420. The contact 422 may be any suitable conductive material. The contact 422 may be separated from the gate stack 412 by the spacers 414. Additionally, an insulating plug 435 may be disposed in the gap between the barrier 430 and the bottom of the source/drain region 420. The insulating plug 435 may comprise an oxide or the like.

Referring now to Figure 41, a cross-sectional illustration of the device after the substrate 401 is removed is shown, in accordance with an embodiment. In an embodiment, the substrate 401 may be removed with an etching process. In an embodiment, the etching process is an isotropic etching process. The barrier 430 protects the bottom surface of the source/drain region 420 during the etching process. The wings 433 extend out and define a recess 437 adjacent to a bottom portion of the source/drain region 420. In some embodiments, the entire substrate 401 is not removed, and residual portions of the substrate 401 may remain in the recesses 437, similar to the embodiment shown in Figure 3B.

Referring now to Figure 4J, a cross-sectional illustration of the device after a replacement substrate 402 is provided on the backside is shown, in accordance with an embodiment. In an embodiment, the replacement substrate 402 may comprise an ILD material, such as those described in greater detail above. The low conductivity of the replacement substrate 402 substantially eliminates the problem of subfin leakage. As such, improved performance is provided for nanowire devices, without the need for high concentration doping of the substrate, and without damaging the source/drain region during the substrate replacement.

Figure 5 illustrates a computing device 500 in accordance with one implementation of an embodiment of the disclosure. The computing device 500 houses a board 502. The board 502 may include a number of components, including but not limited to a processor 504 and at least one communication chip 506. The processor 504 is physically and electrically coupled to the board 502. In some implementations the at least one communication chip 506 is also physically and electrically coupled to the board 502. In further implementations, the communication chip 506 is part of the processor 504.

Depending on its applications, computing device 500 may include other components that may or may not be physically and electrically coupled to the board 502. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 506 enables wireless communications for the transfer of data to and from the computing device 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing device 500 includes an integrated circuit die packaged within the processor 504. In an embodiment, the integrated circuit die of the processor may comprise a nanowire or nanoribbon transistor with a barrier layer between the source/drain region and the ILD replacement substrate, as described herein. The term "processor" may refer to any device or portion of a device that processes electronic data from registers and/or memory to transform that electronic data into other electronic data that may be stored in registers and/or memory.

The communication chip 506 also includes an integrated circuit die packaged within the communication chip 506. In an embodiment, the integrated circuit die of the communication chip may comprise a nanowire or nanoribbon transistor with a barrier layer between the source/drain region and the ILD replacement substrate, as described herein.

In further implementations, another component housed within the computing device 500 may comprise a nanowire or nanoribbon transistor with a barrier layer between the source/drain region and the ILD replacement substrate, as described herein.

In various implementations, the computing device 500 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 500 may be any other electronic device that processes data.

Figure 6 illustrates an interposer 600 that includes one or more embodiments of the disclosure. The interposer 600 is an intervening substrate used to bridge a first substrate 602 to a second substrate 604. The first substrate 602 may be, for instance, an integrated circuit die. The second substrate 604 may be, for instance, a memory module, a computer motherboard, or another integrated circuit die. In an embodiment, one of both of the first substrate 602 and the second substrate 604 may comprise a nanowire or nanoribbon transistor with a barrier layer between the source/drain region and the ILD replacement substrate, in accordance with embodiments described herein. Generally, the purpose of an interposer 600 is to spread a connection to a wider pitch or to reroute a connection to a different connection. For example, an interposer 600 may couple an integrated circuit die to a ball grid array (BGA) 606 that can subsequently be coupled to the second substrate 604. In some embodiments, the first and second substrates 602/604 are attached to opposing sides of the interposer 600. In other embodiments, the first and second substrates 602/604 are attached to the same side of the interposer 600. And in further embodiments, three or more substrates are interconnected by way of the interposer 600.

The interposer 600 may be formed of an epoxy resin, a fiberglass-reinforced epoxy resin, a ceramic material, or a polymer material such as polyimide. In further implementations, the interposer 600 may be formed of alternate rigid or flexible materials that may include the same materials described above for use in a semiconductor substrate, such as silicon, germanium, and other group III-V and group IV materials.

The interposer 600 may include metal interconnects 608 and vias 610, including but not limited to through-silicon vias (TSVs) 612. The interposer 600 may further include embedded devices 614, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 600. In accordance with embodiments of the disclosure, apparatuses or processes disclosed herein may be used in the fabrication of interposer 600.

Thus, embodiments of the present disclosure may comprise a nanowire or nanoribbon transistor with a barrier layer between the source/drain region and the ILD replacement substrate.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a semiconductor device, comprising: a substrate, wherein the substrate is a dielectric material; a vertical stack of semiconductor channels over the substrate; a source at a first end of the semiconductor channels; a drain at a second end of the semiconductor channels; and a barrier between a bottom surface of the source and the substrate.

Example 2: the semiconductor device of Example 1, wherein a width of the barrier is substantially equal to a width of the source.

Example 3: the semiconductor device of Example 1 or Example 2, wherein the barrier has a u-shaped cross-section.

Example 4: the semiconductor device of Examples 1-3, wherein the barrier is a dielectric material that is a different material than the substrate.

Example 5: the semiconductor device of Examples 1-4, further comprising: a gate stack around the vertical stack of semiconductor channels, wherein edge surfaces of the gate stack are contacted by spacers.

Example 6: the semiconductor device of Example 5, wherein the spacers and the barrier comprise the same material.

Example 7: the semiconductor device of Examples 1-6, wherein an oxide is provided between the barrier and the source.

Example 8: the semiconductor device of Examples 1-7, wherein a bottom surface of the source is below a top surface of the substrate.

Example 9: the semiconductor device of Examples 1-8, wherein a cross-section of the barrier is u-shaped with lateral wings.

Example 10: the semiconductor device of Example 9, further comprising a semiconductor region contacting the lateral wings.

Example 11: the semiconductor device of Example 9 or Example 10, wherein the lateral wings are on opposite sides of the u-shape.

Example 12: a method of forming a semiconductor device, comprising: providing a fin with alternating sacrificial layers and channel layers over a semiconductor substrate; forming a source trench in the fin, wherein the source trench extends into the semiconductor substrate; laterally recessing the sacrificial layers to form lateral recesses; disposing a cavity spacer in the lateral recesses and the source trench; etching the cavity spacer to isolate a barrier at a bottom of the source trench; growing a source in the source trench; replacing the sacrificial layers with a gate stack; removing the semiconductor substrate; and disposing an interlayer dielectric (ILD) over a backside of the semiconductor device.

Example 13: the method of Example 12, wherein the barrier has a u-shaped cross-section.

Example 14: the method of Example 13, wherein the barrier further comprises lateral wings.

Example 15: the method of Example 14, wherein removing the semiconductor substrate comprises an etching process, and wherein the lateral wings protect corners of the source.

Example 16: the method of Example 15, wherein portions of the semiconductor substrate above the wings are not removed.

Example 17: the method of Examples 12-16, further comprising: forming a mask over the bottom of the spacer prior to etching the cavity spacer to isolate the barrier at the bottom of the source trench.

Example 18: a nanowire device, comprising: a dielectric substrate; a stack of nanowire channels surrounded by a gate stack; a source at an end of the nanowire channels, wherein the source extends into the dielectric substrate; and a barrier between a bottom surface of the source and the dielectric substrate.

Example 19: the nanowire device of Example 18, wherein the barrier has a u-shaped cross-section.

Example 20: the nanowire device of Example 19, wherein vertical arms of the barrier directly contact the bottom surface of the source.

Example 21: the nanowire device of Example 19 or Example 20, wherein the barrier further comprises lateral wings extending out from sides of the barrier.

Example 22: the nanowire device of Examples 18-21, wherein a width of the source is substantially equal to a width of the barrier.

Example 23: the electronic system, comprising: a board; a package substrate coupled to the board; and a die coupled to the package substrate, wherein the die comprises: a substrate, wherein the substrate is a dielectric material; a vertical stack of semiconductor channels over the substrate; a source at a first end of the semiconductor channels; a drain at a second end of the semiconductor channels; and a barrier between a bottom surface of the source and the substrate.

Example 24: the electronic system of Example 23, wherein the barrier has a u-shaped cross-section.

Example 25: the electronic system of Example 24, wherein the barrier further comprises lateral wings.

## Claims

1. A semiconductor device, comprising:
a substrate, wherein the substrate is a dielectric material;
a vertical stack of semiconductor channels over the substrate;
a source at a first end of the semiconductor channels;
a drain at a second end of the semiconductor channels; and
a barrier between a bottom surface of the source and the substrate.

2. The semiconductor device of claim 1, wherein a width of the barrier is substantially equal to a width of the source.

3. The semiconductor device of claim 1 or 2, wherein the barrier has a u-shaped cross-section.

4. The semiconductor device of claim 1, 2 or 3, wherein the barrier is a dielectric material that is a different material than the substrate.

5. The semiconductor device of claim 1, 2, 3 or 4, further comprising:
a gate stack around the vertical stack of semiconductor channels, wherein edge surfaces of the gate stack are contacted by spacers.

6. The semiconductor device of claim 5, wherein the spacers and the barrier comprise the same material.

7. The semiconductor device of claim 1, 2, 3, 4, 5 or 6, wherein an oxide is provided between the barrier and the source.

8. The semiconductor device of claim 1, 2, 3, 4, 5, 6 or 7, wherein a bottom surface of the source is below a top surface of the substrate.

9. The semiconductor device of claim 1, 2, 3, 4, 5, 6, 7 or 8, wherein a cross-section of the barrier is u-shaped with lateral wings.

10. The semiconductor device of claim 9, further comprising a semiconductor region contacting the lateral wings.

11. The semiconductor device of claim 9 or 10, wherein the lateral wings are on opposite sides of the u-shape.

12. A method of forming a semiconductor device, comprising:
providing a fin with alternating sacrificial layers and channel layers over a semiconductor substrate;
forming a source trench in the fin, wherein the source trench extends into the semiconductor substrate;
laterally recessing the sacrificial layers to form lateral recesses;
disposing a cavity spacer in the lateral recesses and the source trench;
etching the cavity spacer to isolate a barrier at a bottom of the source trench;
growing a source in the source trench;
replacing the sacrificial layers with a gate stack;
removing the semiconductor substrate; and
disposing an interlayer dielectric (ILD) over a backside of the semiconductor device.

13. The method of claim 12, wherein the barrier has a u-shaped cross-section.

14. The method of claim 13, wherein the barrier further comprises lateral wings.

15. The method of claim 14, wherein removing the semiconductor substrate comprises an etching process, and wherein the lateral wings protect corners of the source.
